# EUROPÄISCHE PATENTSCHRIFT

(11) **EP 2 299 496 B1**
(45) Veröffentlichungstag und Bekanntmachung des Hinweises auf die Patenterteilung: **26.06.2019**
(21) Anmeldenummer: 10176519.6
(22) Anmeldetag: 14.09.2010
(51) Int. Cl.: H01L 31/0224, H01L 31/18, H01L 21/268, B23K 26/40, H01L 21/60, H01L 23/488, B23K 26/06, H01L 31/068

(54) **Verfahren zur Herstellung eines Kontaktbereichs eines elektronischen Bauteils**
Method for producing a contact area of an electronic component
Procédé de fabrication d'une zone de contact d'un composant électronique

(30) Priorität: 17.09.2009 DE 102009044038
(43) Veröffentlichungstag der Anmeldung: 23.03.2011
(73) Patentinhaber: Fraunhofer Gesellschaft zur Förderung der angewandten Forschung e.V., 80686 München (DE)
(72) Erfinder: Metz, Axel, 63755 Alzenau (DE); Bagus, Stefan, 36103 Flieden (DE); Dauwe, Stefan, 63825 Blankenbach (DE); Droste, Tobias, 64285 Darmstadt (DE); Roth, Peter, 63450 Hanau (DE); Teppe, Andreas, 78467 Konstanz (DE)

(56) Entgegenhaltungen:
- EP-A1- 2 083 445
- EP-A2- 2 136 407
- DE-A1- 19 542 973
- JP-A- 2007 201 007
- SCHNEIDERLOECHNER E ET AL: "LASER-FIRED CONTACTS (LFC)", 17TH. E.C. PHOTOVOLTAIC SOLAR ENERGY CONFERENCE. MUNICH, GERMANY, OCT. 22 - 26, 2001; [PROCEEDINGS OF THE INTERNATIONAL PHOTOVOLTAIC SOLAR ENERGY CONFERENCE], MUNICH : WIP-RENEWABLE ENERGIES, DE, Bd. CONF. 17, 22. Oktober 2001 (2001-10-22), Seiten 1303-1306, XP001139682, ISBN: 978-3-936338-08-9

## Beschreibung

Die Erfindung bezieht sich auf ein Verfahren zur Herstellung von zumindest einem lokalen Kontaktbereich eines Substrats eines elektronischen Bauelementes zum Kontaktieren des Bereichs mit einem Verbinder, wobei das Substrat kontaktseitig mit einer aus Aluminium bestehenden oder Aluminium enthaltenden gesinterten porösen Schicht direkt versehen ist.

In der Halbleiterfertigung, insbesondere der Solarzellenproduktion, werden aus Produktionskostengründen gesinterte Metallkontakte auf der Vorder- oder Rückseite der Zelle eingesetzt.

Üblicherweise befindet sich auf der Rückseite einer Silizium-Solarzelle eine großflächige Aluminiumschicht, die durch Wärmebehandlung während der Herstellung der Solarzelle einem Sinterprozess ausgesetzt wird, wodurch gleichzeitig eine Passivierung der Solarzellenrückseite durch ein so genanntes Back-Surface-Field (BSF) geschaffen wird.

Beim Sintern wird die Aluminiumschicht, die sich in direktem Kontakt mit dem als erste Schicht zu bezeichnenden Siliziumsubstrat befindet, an der Grenzfläche zwischen der Aluminiumschicht und dem Siliziumsubstrat aufgeschmolzen und legiert mit der angrenzenden ersten Schicht. Beim Abkühlen erstarrt eine hoch mit Al dotierte Siliziumschicht epitaktisch auf der Rückseite des Wafers, also des Substrats. Simultan dazu erstarrt eine mit Silizium angereicherte Al-Schicht auf der Al-Schicht, und am Schluss des Abkühlvorgangs erstarrt ein Al-Si-Eutektikum zwischen der hoch mit Aluminium dotierten Schicht und der mit Silizium angereicherten Schicht. Für die Passivierung der Solarzellenrückseite ist die hoch mit Aluminium dotierte epitaktisch aufgewachsene Siliziumschicht verantwortlich. Durch die hohe Al-Dotierung wird im Halbleitermaterial der Schicht ein Überschuss an negativ geladenen, ortsfesten Al-Akzeptoren gebildet, von denen ein die Minoritätsträger zurücktreibendes elektrisches Feld erzeugt wird, das so genannte Back-Surface-Field.

Wenn sich die Aluminiumschicht über die gesamte Rückseite der Solarzelle bzw. des Substrats erstreckt, gibt es jedoch ein löttechnisches Problem, da es nicht ohne Weiteres möglich ist, z. B. verzinnte oder nicht verzinnte Metallverbinder, insbesondere Kupferverbinder auf der Aluminiumrückseite direkt anzulöten. Um ungeachtet dessen die erforderliche elektrische Kontaktierung durchzuführen, werden üblicherweise Silberkontaktleiterbahnen oder Lötpunkte direkt auf die Substratoberfläche durch Siebdruck, Tampondruck oder andere geeignete Druckverfahren aufgebracht und an diese die verzinnten Kupferbänder angelötet. Folglich ist im Bereich der Lötkontakte eine Aussparung der Aluminiumschicht vorgesehen mit der Folge, dass sich in diesem Bereich kein Back-Surface-Field ausbilden kann, so dass die Solarzellenrückseitenfläche nicht vollständig elektrisch passiviert ist und hierdurch lokal geringere Fotoströme auftreten.

Da Silber als Rohstoff ein teures Material ist, sollte zur Reduzierung der Herstellungskosten darauf verzichtet werden. Daher ist es wünschenswert, den Ag-Kontakt ganz zu vermeiden.

Ein unmittelbares Löten der Kontaktbänder auf der Aluminiumschicht ist aus mehreren Gründen schwer möglich. Ein Grund liegt in der oxidierten Oberfläche der Al-Partikel. Ein weiterer Grund ist, dass die Aluminiumoberseite aufgrund des Sinterprozesses nicht im hinreichenden Umfang zusammenhängend ausgebildet ist. So entsteht während des Sinterprozesses über der mit Si dotierten Legierungsschicht eine Al-Schicht in Form von aus einzelnen kugelförmigen zusammen gesinterten Al-Partikeln (Sinterschicht), bei der kein geschlossener, sondern ein relativ locker gesinterter Verbund aus Aluminium vorliegt, der in Abhängigkeit von der Zusammensetzung der Aluminiumpaste bzw. der Prozessparameter beim Sintern mehr oder weniger porös ist.

Sollte es ungeachtet dessen gelingen, auf dieser Sinter-Aluminium-Schicht zu löten, so würde jedoch aufgrund der Porosität und hierdurch bedingten Instabilität der Schicht nur ein sehr geringer Halt gegeben sein. Dieser geringere Halt äußert sich in geringen Abzugskräften von ca. 2-8 N, wobei die Sinterschicht in sich auseinander gerissen wird, so dass man auf beiden Seiten der Abrissstelle die Kugelstruktur der Partikel erkennt.

Gleiches erfolgt, wenn die Lötverbindung auf der Aluminiumschicht den in einem Modul unter Betriebsbedingungen wirkenden Zugkräften ausgesetzt ist. Es kann zu kleinen Rissen kommen, die zu einer geringeren Haltbarkeit der Lötstelle führen und auch höhere Übergangswiderstände zur Folge haben können, oder die Verbindung kann als Ganzes abreißen und der mechanische und elektrische Kontakt ist vollständig zerstört.

Aus der DE 10 2007 012 277 A1 ist ein Verfahren zur Herstellung einer Solarzelle bekannt. In einem Verfahrensschritt wird Aluminium großflächig auf die Rückseite des Halbleitersubstrats aufgebracht und in dieses hineinlegiert. Das nicht in das Silizium hineinlegierte Aluminium wird in einem Ätzschritt zumindest bereichsweise entfernt. Dies erfordert einen prozesstechnischen Aufwand, der sich im Rahmen einer Produktionslinie zur Herstellung von Solarzellen negativ auswirkt.

Die EP 1 739 690 A1 bezieht sich auf eine Solarzelle, bei der nach Ausbilden eines Back-Surface-Field eine zuvor ausgebildete gesinterte Aluminiumschicht chemisch entfernt wird.

Um elektrisch leitende Kontakte auf Solarzellen herzustellen, wird nach der US 2003/0108664 A1 eine Precursor-Mischung aufgetragen. Diese kann Aluminium enthalten. Um das Material zu sintern, kann ein gepulster Laserstrahl eingesetzt werden.

Um elektrische Kontakte auf Halbleitersubstrate aufzubringen, sieht die DE 10 2006 040 352 B1 vor, auf das Halbleitersubstrat aufgetragenes metallisches Pulver mittels Laserstrahls zu sintern. Nichtgesintertes Material wird sodann entfernt.

Um Metallhalbleiterkontakte nach der EP 2 003 699 A1 herzustellen, wird in eine auf eine Solarzelle aufgebrachte Aluminiumsinterschicht ein lötbares Material eingesintert.

Der älteren, jedoch nicht vorveröffentlichten EP 2 136 407 A2 ist eine Solarzelle zu entnehmen, entlang deren Rückseite eine poröse Aluminiumschicht läuft, die in Bereichen, in denen Kontakte ausgebildet werden sollen, teilweise durch Laserablation entfernt ist. In die so gebildeten Öffnungen wird Lotmaterial eingebracht.

Gegenstand der JP 2007-201007 A ist eine Solarzelle mit rückseitig verlaufender poröser Aluminiumschicht. Um Kontakte herzustellen, werden in der Aluminiumschicht durch chemisches Ätzen oder auf mechanische Weise Öffnungen ausgebildet.

Der vorliegenden Erfindung liegt die Aufgabe zu Grunde, ein Verfahren der eingangs genannten Art so weiterzubilden, dass ein mechanisch haltbarer elektrisch einwandfrei verbindbarer wie lötbarer Kontaktbereich zur Verfügung gestellt wird. Auch soll im Vergleich zum Stand der Technik eine prozesstechnische Vereinfachung gegeben sein.

Erfindungsgemäß wird die Aufgabe dadurch gelöst, dass die gesinterte poröse Schicht in dem Kontaktbereich berührungslos mit konzentrierter elektromagnetischer Strahlung, vorzugsweise Laserstrahlung verdichtet und/oder entfernt wird, wobei
a) die gesinterte poröse Schicht teilweise entfernt und teilweise verdichtet wird, oder
b) die gesinterte poröse Schicht zumindest in einem Bereich derart verdichtet wird, dass sich Bereiche unterschiedlicher Dichten ergeben, oder
c) die gesinterte poröse Schicht derart verdichtet wird, dass sich ein Dichtegradient ergibt, oder
d) die gesinterte poröse Schicht in zumindest einem Bereich derart verdichtet wird, dass sich zumindest zwei Schichten unterschiedlicher Dichten ergeben, oder
e) die gesinterte poröse Schicht in dem auszubildenden Kontaktbereich zunächst außenseitig entfernt und sodann verbleibender Bereich verdichtet wird.

Insbesondere ist vorgesehen, dass der Bereich mit konzentrierter elektromagnetischer Strahlung, vorzugsweise Laserstrahlung beaufschlagt wird.

Aufgrund der erfindungsgemäßen Lehre hat sich überraschenderweise gezeigt, dass durch das Beaufschlagen mit konzentrierter elektromagnetischer Strahlung, vorzugsweise Laserstrahlung und das hierdurch erfolgende lokale Verdichten bzw. Entfernen von Material der gesinterte porösen Schicht ein Kontaktbereich ausbildbar ist, der eine mechanisch stabile Verschaltung mittels bekannter Verbindungstechniken wie z. B. Ultraschalllöten ermöglicht. Dabei ist durch die gesinterte poröse Aluminiumschicht der Vorteil gegeben, dass diese in einem Umfang verdichtet werden kann, dass sich eine kratzfeste Aluminiumoberfläche mit hervorragender mechanischer Haftung ergibt. Folglich ist es nicht erforderlich, z. B. in Maskentechnik unmittelbar auf dem Substrat einen Lötkontakt aus einem anderen Material als Aluminium auszubilden, so dass infolgedessen der bei einer Solarzelle als Bauteil der immanente Nachteil vermieden wird, dass im Bereich des Kontaktes das Back-Surface-Field unterbrochen wird.

Durch das Verdichten ergibt sich ein Bereich, der mechanisch stabiler ist als eine poröse Schicht aus gleichem Material.

Insbesondere ist vorgesehen, dass die gesinterte poröse Schicht mit konzentrierter elektromagnetischer Strahlung einer Wellenlänge λ mit 200 nm ≤ λ ≤ 11 000 nm beaufschlagt wird.

Bevorzugterweise wird zur berührungslosen Verdichtung bzw. Entfernen von Bereichen der porösen Schicht ein Laser verwendet, der IR-Strahlung mit einer Wellenlänge ≥ 800 nm, vorzugsweise λ ≥ 1000 nm, insbesondere mit λ = 1064 nm, insbesondere im Nahinfrarotbereich emittiert. Vorzugsweise wird ein Festkörperlaser wie Nd:YVO₄-Laser oder Nd:YAG-Laser eingesetzt. Dabei ist insbesondere bevorzugt ein Festkörperlaser, der Laserstrahlung einer Wellenlänge λ mit λ = 1064 nm aussendet.

Beim Ausbilden des oder der Kontaktbereiche sollte der Laser im Pulsbetrieb bzw. gütegeschalteten Betrieb arbeiten. Um die Energie über einen definierten Bereich zu bündeln und um Hot-Spots zu vermeiden, ist des Weiteren vorgesehen, dass beim Strukturieren der Rückelektrodenschicht der Laserstrahl ein Top-Hat-förmiges Strahlprofil aufweist.

Zur Beeinflussung des Strahlprofils ist alternativ oder ergänzend vorgesehen, dass zwischen dem Laser und dem Substrat eine Strahlumformungseinrichtung wie refraktive oder diffraktive Optik oder eine Blende angeordnet wird.

Insbesondere sollte eine Laserstrahlung einer Wellenlänge benutzt werden, bei der die optische Absorption der porösen Schicht zumindest 0,5 %, insbesondere mindestens 10 % beträgt.

Es sollte eine Wellenlänge eingesetzt werden, die in der gesinterten porösen Schicht zum Erwärmen dieser derart absorbiert wird, dass im Bereich der beaufschlagten Laserstrahlung zur Bildung des Kontaktbereichs das Schichtmaterial verdampft.

Anstelle von Laserstrahlung kann Wärmeenergie durch beliebige berührungslose Strahlungsenergie wie durch Linsen oder Spiegel fokussiertes Licht beliebiger Wellenlänge verwendet werden.

Zu dem Begriff Verdichten ist ergänzend auszuführen, dass hierdurch die Behandlung des Schichtmaterials bzw. Werkstoffs zu verstehen ist, um eine Erhöhung der Dichte um zumindest 10 % und höchstens 100 % zu erzielen. Eine 100 %ige Erhöhung der Dichte bedeutet das vollständige Aufschmelzen der Schicht bzw. Bereiche dieser durch den Energieeintrag und somit die Erzeugung einer an sich z. B. kristallinen Schicht, die eine Porosität nicht mehr aufweist, d. h. mit 100 %iger Dichte.

Unter Entfernen wird die Behandlung der gesinterten porösen Schicht verstanden, durch die diese teilweise oder ganz entfernt wird. Teilweises Entfernen soll grundsätzlich beinhalten, dass zumindest 10 % der ursprünglichen Schichtdicke der gesinterten porösen Schicht entfernt wird. Vollständiges Entfernen bedeutet, dass keine porösen Teilbereiche der ursprünglichen Schicht nach der Behandlung auf dem Substrat verbleiben, und zwar in den Bereichen, in denen eine Kontaktierung erfolgen soll. Bei einer Solarzelle würde dies bedeuten, dass ein Abtrag der porösen Schicht bis zu dem beim Sintern gebildeten Al-Si-Eutektikum erfolgt.

Die erfindungsgemäße Lehre zielt darauf ab, dass die Behandlung der Schicht derart erfolgt, dass ein geeigneter Haftgrund zur Verfügung steht, auf den gelötet bzw. eine lötfähige Schicht aufgebracht werden kann. Hierbei kann es sich z. B. um eine Zinn-Schicht handeln.

Das Löten kann selbstverständlich durch andere eine stoffschlüssige Verbindung ermöglichende Verbindungsarten ersetzt werden, wie Schweißen oder Kleben.

Das Verdichten bzw. vollständige oder teilweise Umschmelzen schließt auch eine vollständige oder teilweise Phasenumwandlung ein, so dass sich unterschiedliche Legierungen bzw. Legierungskonzentrationen ergeben.

Insbesondere wird das erfindungsgemäße Verfahren bei einer Solarzelle als elektronisches Bauteil verwendet, das eine aus Halbleitermaterial bestehende erste Schicht als Substrat, eine auf dieser verlaufende zweite Schicht als die gesinterte poröse Schicht aus Alumium oder Aluminium enthaltend, mindestens zwei zwischen der ersten und zweiten Schicht verlaufende aus den Materialien der ersten und zweiten Schicht gebildete Zwischenschichten enthält, wobei die der zweiten Schicht zugewandte erste Zwischenschicht ein eutektisches Gemisch aus den Materialien der ersten und zweiten Schicht enthalten kann, sowie den eine elektrisch leitende Verbindung mit der ersten Schicht bildenden und von der zweiten Schicht ausgehenden oder diese durchsetzenden durch das berührungslose Verdichten und/oder Entfernen von Material der zweiten Schicht gebildeten elektrisch leitenden Kontaktbereich umfasst, wobei nach dem Verdichten und/oder Entfernen des Materials der porösen Schicht in dem Kontaktbereich dieser mit einem Verbinder, insbesondere durch Löten, wie Ultraschalllöten, elektrisch leitend verbunden wird.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines der Zeichnung zu entnehmenden bevorzugten Ausführungsbeispiels.

Es zeigen:
- Fig. 1: eine Prinzipdarstellung eines Halbleiterbauelementes,
- Fig. 2: eine Prinzipdarstellung eines Halbleiterbauelementes nach dessen Behandlung gemäß einer ersten Ausführungsform,
- Fig. 3: eine Prinzipdarstellung eines Halbleiterbauelementes nach dessen Behandlung gemäß einer zweiten Ausführungsform,
- Fig. 4: eine Prinzipdarstellung eines Halbleiterbauelements nach dessen Behandlung gemäß einer dritten Ausführungsform,
- Fig. 5: eine Prinzipdarstellung eines Halbleiterbauelementes nach dessen Behandlung gemäß einer vierten Ausführungsform und
- Fig. 6: eine Prinzipdarstellung eines Halbleiterbauelementes nach dessen Behandlung gemäß einer fünften Ausführungsform.

Den Figuren ist rein prinzipiell ein Ausschnitt eines Halbleiterbauelementes zu entnehmen, das nachstehend aus Gründen der Vereinfachung als Solarzelle bezeichnet wird. Dargestellt sind dabei ein aus Silizium bestehendes Substrat 10, also Halbleitermaterialschicht - nachstehend auch Halbleiterschicht genannt -, auf dessen bzw. deren Vorderseite in gewohnter Weise halbleitende Schichten zur Ausbildung eines pn-Übergangs sowie Frontkontakte und gegebenenfalls Passivierungsschichten aufgetragen sein können. Insoweit wird jedoch auf hinlänglich bekannte Konstruktionen bzw. Aufbauten von Halbleiterbauelementen wie Solarzellen verwiesen, ohne dass es näherer Erläuterungen bedarf.

Auf die als erste Schicht bezeichnete Halbleiterschicht 10 wird z. B. mittels Siebdruck, Tampondruck, thermisches Spritzen, eine Schicht aus Aluminium oder Aluminium enthaltend aufgebracht. Diese Schicht wird nachstehend als Aluminium-Schicht oder nur Schicht bezeichnet. Die Schicht wird bei der Herstellung der Solarzelle gesintert, wodurch sich eine äußere Aluminiumsinterschicht 12 als zweite Schicht ergibt. Zwischen der Aluminiumsinterschicht 12 und dem Siliziumsubstrat 10 werden bei der Herstellung eine das Back-Surface-Field bildende mit Aluminium dotierte Siliziumschicht 14 und eine mit Silizium dotierte Aluminiumschicht 16 mit Al-Si-Eutektikum 18 ausgebildet. Insoweit wird jedoch ebenfalls auf den hinlänglich bekannten Stand der Technik verwiesen. Die mit Silizium dotierte Aluminiumschicht 16 wird als erste Zwischenschicht und die mit Aluminium dotierte Siliziumschicht wird als zweite Zwischenschicht 14 bezeichnet.

Die äußere oder zweite aus Aluminium bestehende Schicht 12 ist aufgrund des Sinterprozesses porös und weist demzufolge eine Vielzahl von Hohlräumen auf.

Zu den Schichten 10, 12, und Zwischenschichten 14, 16 einschließlich dem Eutektikum 18 ist anzumerken, dass diese zeichnerisch rein prinzipiell dargestellt sind, ohne dass diese die tatsächlichen Dimensionierungen widerspiegeln.

Um auf die als die zweite Schicht bezeichnete Aluminiumsinterschicht 12 einen Verbinder wie Kupferverbinder zum Kontaktieren auflöten zu können, wird in der Sinterschicht 12 ein Kontaktbereich 20 ausgebildet, der erfindungsgemäß insbesondere durch berührungsloses Verdichten bzw. Entfernen des Aluminiummaterials mittels konzentrierter elektromagnetischer Strahlung erfolgt, das sich in dem Bereich der Schicht 12 befindet, indem der Kontaktbereich 12 ausgebildet wird.

Zum berührungslosen Verdichten bzw. Entfernen kann ein Festkörperlaser 21 wie Nd:YVO₄-Laser eingesetzt werden, also ein solcher, der als Wirtskristalle Yttrium-Vanadat aufweist. Auch kann der Wirtskristall Yttrium-Aluminium-Granat (YAG) sein, so dass ein Nd:YAG-Festkörperlaser zum Einsatz kommt. Zur Dotierung wird vorzugsweise Neodym verwendet, so dass ein Festkörperlaser mit einer Wellenlänge von 1064 nm zur Verfügung steht. Gegebenenfalls kann auch ein Erbium wie Ytterbium oder ein anderes Element zur Dotierung des Lasers verwendet werden. Ein neodymdotierter Yttrium-Vanadat-Laser (Nd:YVO4-Laser) oder neodymdotierter YAG (Nd:YAG-Laser) ist besonders bevorzugt.

Um der Laserstrahlung 23 ein gewünschtes Profil aufzuzwingen, können in den Strahlengang optische Einrichtungen zur Strahlaufweitung einer Blende oder ein optisches Strahlumformsystem wie refraktive oder diffrative Optik angeordnet werden.

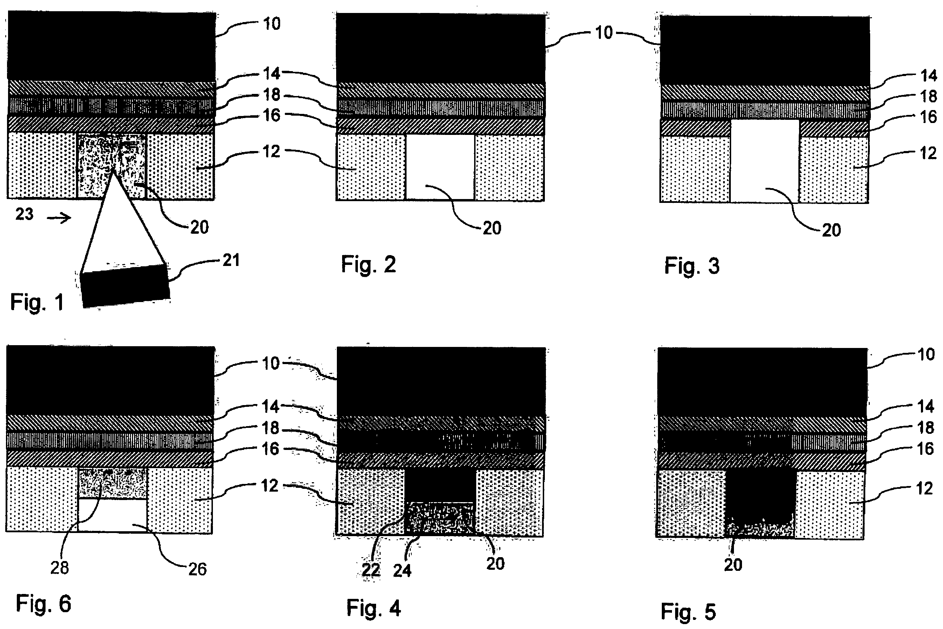

Durch die diesbezüglichen Maßnahmen lassen sich gezielt Kontaktbereiche 20 in der porösen Aluminiumschicht 12 ausbilden, die eine mechanisch stabile Verschaltung mittels bekannter Verbindungstechniken wie z. B. Ultraschalllöten ermöglicht. Insbesondere erfolgt eine Beaufschlagung mit konzentrierter elektromagnetischer Strahlung in einem Umfang, dass sich ein Kontaktbereich aus einer Aluminiumschicht ergibt, der hochverdichtet, teilweise verdichtet oder mit einem Dichtungsgradienten über die Dichte der vormals porösen Schicht versehen ist (Fig. 1, 4, 5) und eine gegebenenfalls kratzfeste Aluminiumoberfläche aufweist, die zu einer guten mechanischen Haftung führt.

Die Erfindung wird jedoch auch dann nicht verlassen, wenn in dem auszubildenden Kontaktbereich das Material der zweiten Schicht 12 sowie gegebenenfalls einschließlich der Schichten 16 und 18 oder auch nur einschließlich der Schicht 16 (Fig. 2, 3) vollständig verdampft und somit eine Kontaktierung unmittelbar unterhalb der an der äußeren Schicht 12 angrenzenden Zwischenschicht 16 erfolgt.

Die verschiedenen Möglichkeiten, die sich aufgrund der erfindungsgemäßen Lehre ergeben, sind grundsätzlich den Fig. 4 bis 6 zu entnehmen. Die erfindungsgemäßen Verfahrensweisen werden dabei erneut anhand einer Solarzelle erläutert, so dass für gleiche Elemente gleiche Bezugszeichen verwendet werden.

Die Fig. 2 und 3 (Ausführungsformen nicht Teil der Erfindung) sollen verdeutlichen, dass zur Zurverfügungstellung eines Kontaktbereichs 20 die Aluminiumsinterschicht 12 (Fig. 2) oder diese zusammen mit der angrenzenden mit Silizium dotierten Aluminiumschicht 16 entfernt werden können (Fig. 3).

Die Fig. 4 und 5 sollen prinzipiell zeigen, dass im gewünschten Umfang eine Verdichtung der Aluminiumsinterschicht 12 erfolgen kann, um einen Kontaktbereich 20 auszubilden, der die gewünschte mechanische Stabilität aufweist, um eine Kontaktierung vorzunehmen. Dabei ist nach dem Ausführungsbeispiel der Fig. 4 die Sinterschicht 12 in Bereichen 22, 24 unterschiedlicher Dichtheit verdichtet worden. Nach dem Ausführungsbeispiel der Fig. 5 ist die Sinterschicht 12 im Kontaktbereich 2 graduell von außen nach innen zunehmend verdichtet worden. Es liegt ein Dichtegradient vor.

Schließlich besteht auch die Möglichkeit, einen Bereich einer Schicht - im Ausführungsbeispiel die Aluminiumsinterschicht 12 - zu entfernen und einen verbleibenden Teil zu verdichten. Die entsprechenden Bereiche sind in Fig. 6 mit dem Bezugszeichen 26 (entfernter Bereich) und 28 (verdichteter Bereich) gekennzeichnet.

Ist in den Ausführungsbeispielen in oder unterhalb der Schicht 12 ein einziger Kontaktbereich 20 dargestellt, so kann selbstverständlich im Umfang der benötigten Verbindungen eine entsprechende Anzahl von Kontaktbereichen nach der erfindungsgemäßen Lehre hergestellt werden.

Unabhängig von Obigem ist darauf hinzuweisen, dass die erfindungsgemäßen Verfahren nicht zwingend nur auf Rückseiten von Halbleiterbauelementen wie Solarzellen anzuwenden sind. Vielmehr gilt Gleiches für die Vorderseiten.

Ferner ist vorgesehen, dass das erfindungsgemäße Verdichten und/oder Entfernen bzw. Entfernen und/oder Verdichten insbesondere ausschließlich in Bereichen erfolgt, in denen Verbindungen mit einem Verbinder wie Zellenverbinder hergestellt werden sollen. Auch erstreckt sich die zuvor ausgebildete gesinterte poröse Aluminiumschicht vorzugsweise entlang der gesamten Rückseite der Solarzelle.

Ebenso ist darauf hinzuweisen, dass nach der Anwendung des erfindungsgemäßen Verfahrens ergänzend eine oder mehrere Schichten auf die behandelten Bereiche aufgetragen werden können, bevor der eigentliche Löt- oder Verbindungsprozess durchgeführt wird.

Die Morphologie der verdichteten Schicht stellt in besonderem Maße einen Nachweis der Anwendung dieser Erfindung dar, wenn üblicherweise Teilbereiche der betrachteten Aluminium-Schicht höhere Dichten oder Dichtegradienten gegenüber nicht behandelten Teilbereichen aufweisen.

Ebenso stellt das Fehlen einer porösen Schicht in besonderem Maße einen Nachweis der Anwendung dieser Erfindung dar, wenn z. B. Teilbereiche der betrachteten Aluminium-Schicht gegenüber nicht behandelten Teilbereichen ganz oder teilweise fehlen.

## Patentansprüche

1. Verfahren zum Ausbilden zumindest eines lokalen Kontaktbereichs eines Substrats eines elektrischen Bauelementes zum Kontaktieren des Kontaktbereichs mit einem Verbinder, wobei das Substrat kontaktseitig mit einer aus Aluminium bestehenden oder Aluminium enthaltenden gesinterten porösen Schicht direkt versehen ist,
**dadurch gekennzeichnet,**
**dass** die gesinterte poröse Schicht in dem auszubildenden Kontaktbereich mit konzentrierter elektromagnetischer Strahlung verdichtet und/oder entfernt wird, wobei
a) die gesinterte poröse Schicht teilweise entfernt und teilweise verdichtet wird, oder
b) die gesinterte poröse Schicht zumindest in einem Bereich derart verdichtet wird, dass sich Bereiche unterschiedlicher Dichten ergeben, oder
c) die gesinterte poröse Schicht derart verdichtet wird, dass sich ein Dichtegradient ergibt, oder
d) die gesinterte poröse Schicht in zumindest einem Bereich derart verdichtet wird, dass sich zumindest zwei Schichten unterschiedlicher Dichten ergeben, oder
e) die gesinterte poröse Schicht in dem auszubildenden Kontaktbereich zunächst außenseitig entfernt und sodann verbleibender Bereich verdichtet wird.

2. Verfahren nach Anspruch 1,
**dadurch gekennzeichnet,**
**dass** die gesinterte poröse Schicht mit konzentrierter elektromagnetischer Strahlung einer Wellenlänge λ mit 200 nm ≤ λ ≤ 10 000 nm beaufschlagt wird.

3. Verfahren nach Anspruch 1,
**dadurch gekennzeichnet,**
**dass** die gesinterte poröse Schicht in dem auszubildenden Kontaktbereich mit einer Laserstrahlung einer Wellenlänge λ mit λ ≥ 800 nm, vorzugsweise λ ≥ 1000 nm, insbesondere im nahen Infrarotbereich beaufschlagt wird.

4. Verfahren nach zumindest einem der vorgehenden Ansprüche,
**dadurch gekennzeichnet,**
**dass** zur Erzeugung der konzentrierten elektromagnetischen Strahlung ein Neodym dotierter Festkörperlaser (21) mit einer Wellenlänge von λ = 1064 nm oder ein Yttrium-Aluminium-Granat- oder ein Yttrium-Vanadat-Festkörperlaser (21), insbesondere ein Neodym dotierter Yttrium-Aluminium-Granat-Laser (21) oder ein Neodym dotierter Yttrium-Vanadat-Laser verwendet wird.

5. Verfahren nach zumindest einem der vorgehenden Ansprüche,
**dadurch gekennzeichnet,**
**dass** der Laser (21) Laserstrahlung (23) einer Wellenlänge emittiert, bei der die optische Absorption der gesinterten porösen Schicht (12) mindestens 0,5 %, vorzugsweise im Bereich zwischen 10 % und 100 % liegt.

6. Verfahren nach zumindest einem der vorgehenden Ansprüche,
**dadurch gekennzeichnet,**
**dass** ein Laser (21) verwendet wird, der Laserstrahlung mit einer Wellenlänge emittiert, die von der gesinterten porösen Schicht (12) zum Erwärmen dieser derart absorbiert wird, dass das poröse Material im Bereich der beaufschlagten Laserstrahlung zur Bildung des Kontaktbereichs (20) verdampft.

7. Verfahren nach zumindest einem der vorgehenden Ansprüche,
**dadurch gekennzeichnet,**
**dass** zum Ausbilden des Kontaktbereichs (20) der Laser im Pulsbetrieb bzw. gütegeschalteten Betrieb benutzt wird und/oder zur Ausbildung des Kontaktbereichs (20) dem Laserstrahl ein "Top-Hat"-förmiges Strahlprofil aufgezwungen wird, wobei ggfs. zur Strahlbeeinflussung des Laserstrahls (24) zwischen dem Laser (21) und der Schicht (14) eine Strahlumformeinrichtung wie refraktive oder diffraktive Optik oder eine Blende angeordnet wird.

8. Verfahren nach zumindest einem der vorgehenden Ansprüche,
**dadurch gekennzeichnet,**
**dass** der Laser (21) durch einen opto-akustischen Schalter gepulst wird.

9. Verfahren nach zumindest einem der vorgehenden Ansprüche, wobei als elektronisches Bauteil eine Solarzelle verwendet wird, umfassend aus Halbleitermaterial bestehende erste Schicht (10) als das Substrat, eine auf dieser verlaufende zweite Schicht (12) als die gesinterte poröse Schicht aus Aluminium oder Aluminium enthaltend, zumindest zwei zwischen der ersten und zweiten Sicht verlaufende aus den Materialien der ersten und zweiten Schicht ausgebildete Zwischenschichten (16, 14), wobei die der zweiten Schicht (12) zugewandte erste Zwischenschicht (16) ein eutektisches Gemisch (18) aus den Materialien der ersten und zweiten Schicht enthalten kann, sowie den eine elektrisch leitenden Verbindung der ersten Schicht bildenden Kontaktbereich (20), wobei nach dem Verdichten und/oder Entfernen des Materials der gesinterten porösen Schicht in dem auszubildenden Kontaktbereich dieser mit einem Verbinder insbesondere durch Löten wie Ultraschalllöten elektrisch leitend verbunden wird.

10. Verfahren nach zumindest einem der vorhergehenden Ansprüche,
**dadurch gekennzeichnet,**
**dass** nach Verdichten und/oder Entfernen der gesinterten porösen Schicht auf den entsprechenden Bereich eine oder mehrere Schichten aufgebracht werden, mit der bzw. denen die Kontaktierung erfolgt.

## Claims

1. Method for forming at least one local contact area of a substrate of an electrical component for contacting the contact area with a connector, wherein the substrate is directly provided on the contact side with a sintered, porous layer consisting of aluminium or containing aluminium,
**characterized in that**
the sintered, porous layer in the contact area that is to be formed is compacted and/or removed using concentrated electromagnetic radiation, wherein
a) the sintered, porous layer is partially removed and partially compacted, or
b) the sintered, porous layer is compacted in at least one area in such a way that areas of different thickness result, or
c) the sintered, porous layer is compacted in such a way that a density gradient results, or
d) the sintered, porous layer is compacted in at least one area in such a way that at least two layers of different thickness result, or
e) the sintered, porous layer in the contact area that is to be formed is first removed on the outside and the remaining area is then compacted.

2. Method according to Claim 1,
**characterized in that**
the sintered, porous layer is subjected to concentrated electromagnetic radiation of a wavelength λ where 200 nm ≤ λ ≤ 10 000 nm.

3. Method according to Claim 1,
**characterized in that**
the sintered, porous layer in the contact region that is to be formed is subjected to a laser radiation of a wavelength λ where λ ≥ 800 nm, preferably λ ≥ 1000 nm, in particular in the near infra-red region.

4. Method according to at least one of the preceding claims,
**characterized in that**
to generate the concentrated electromagnetic radiation, a neodymium-doped solid-state laser (21) with a wavelength of λ = 1064 nm, or an yttrium-aluminium-gamet or an yttrium-vanadate solid-state laser (21), in particular a neodymium-doped yttrium-aluminium-garnet laser (21), or a neodymium-doped yttrium-vanadate laser is used.

5. Method according to at least one of the preceding claims,
**characterized in that**
the laser (21) emits laser radiation (23) of a wavelength for which the optical absorption of the sintered, porous layer (12) is at least 0.5%, preferably lying in the range between 10% and 100%.

6. Method according to at least one of the preceding claims,
**characterized in that**
a laser (21) is used that emits laser radiation with a wavelength that is absorbed by the sintered, porous layer (12) to heat it in such a way that the porous material in the area exposed to laser radiation evaporates to form the contact area (20).

7. Method according to at least one of the preceding claims,
**characterized in that**
to form the contact area (20) the laser is used in a pulsed or Q-switched mode, and/or that the laser beam is made to adopt a "top hat" beam profile to form the contact area, wherein it may be appropriate for a beam transforming apparatus such as refractive or diffractive optics or an aperture to be arranged between the laser and the layer (14) for influencing the beam of the laser radiation (24).

8. Method according to at least one of the preceding claims,
**characterized in that**
the laser (21) is pulsed by an opto-acoustic switch.

9. Method according to at least one of the preceding claims, wherein a solar cell is used as an electronic component, comprising as the substrate a first layer (10) consisting of semiconductor material, a second layer (12) extending over this as the sintered, porous layer of aluminium or containing aluminium, at least two intermediate layers (16, 14) formed of the materials of the first and second layers extending between the first and second layer, wherein the first intermediate layer (16) facing the second layer (12) can contain a eutectic mixture (18) of the materials of the first and second layers, as well as the contact area (20) forming an electrically conductive connection to the first layer, wherein after the compacting and/or removal of the material of the sintered, porous layer in the contact area that is to be formed, said region is connected in an electrically conductive manner with a connector, in particular through soldering such as ultrasonic soldering.

10. Method according to at least one of the preceding claims,
**characterized in that**
after compacting and/or removing the sintered, porous layer, one or a plurality of layers, with which the contact is made, are applied to the corresponding area.

## Revendications

1. Procédé de formation d'au moins une zone de contact locale d'un substrat d'un composant électrique, pour mettre en contact la zone de contact avec un connecteur, ledit substrat étant directement pourvu côté contact d'une couche poreuse frittée composée d'aluminium ou contenant de l'aluminium,
**caractérisé en ce**
**que** la couche poreuse frittée est compactée et/ou enlevée par rayonnement électromagnétique concentré dans la zone de contact à former, sachant
a) **que** la couche poreuse frittée est en partie enlevée et en partie compactée, ou
b) **que** la couche poreuse frittée est au moins compactée dans une zone de sorte qu'il en ressort des zones de différentes densités, ou
c) **que** la couche poreuse frittée est compactée de sorte qu'il en ressort un gradient de densité, ou
d) **que** la couche poreuse frittée est compactée dans au moins une zone de sorte qu'il en ressort deux couches de différentes densités, ou
e) **que** la couche poreuse frittée est enlevée tout d'abord à l'extérieur de la zone de contact à former, la zone restante étant compactée par la suite.

2. Procédé selon la revendication 1,
**caractérisé en ce**
**que** la couche poreuse frittée est soumise au rayonnement électromagnétique concentré d'une longueur d'onde λ de 200 nm ≤ λ ≤ 10 000 nm.

3. Procédé selon la revendication 1,
**caractérisé en ce**
**que** la couche poreuse frittée dans la zone de contact à former est soumise à un rayonnement laser d'une longueur d'onde λ, λ ≥ 800 nm, de préférence λ ≥ 1000 nm, en particulier dans le domaine de l'infrarouge proche.

4. Procédé selon au moins l'une des précédentes revendications,
**caractérisé en ce**
**qu'**un laser à l'état solide (21) dopé au néodyme avec une longueur d'onde de λ = 1064nm ou un laser à l'état solide (21) au grenat d'yttrium et d'aluminium ou au vanadate d'yttrium, en particulier un laser au grenat d'yttrium et d'aluminium dopé au néodyme (21) ou un laser au vanadate d'yttrium dopé au néodyme, est utilisé pour générer le rayonnement électromagnétique concentré.

5. Procédé selon au moins l'une des précédentes revendications,
**caractérisé en ce**
**que** le laser (21) émet un rayonnement laser (23) d'une longueur d'onde, pour laquelle l'absorption optique de la couche poreuse frittée (12) est d'au moins de 0,5 %, de préférence entre 10 % et 100 %.

6. Procédé selon au moins l'une des précédentes revendications,
**caractérisé en ce**
**qu'**un laser (21) émettant un rayonnement laser avec une longueur d'onde qui est absorbée par la couche poreuse frittée (12) pour réchauffer cette dernière est utilisé, de sorte que le matériau poreux s'évapore dans la zone où le rayonnement laser est appliqué pour former la zone de contact (20).

7. Procédé selon au moins l'une des précédentes revendications,
**caractérisé en ce**
**que** le laser est utilisé en mode pulsé ou en mode commutation Q pour la formation de la zone de contact (20) et/ou qu'un profil de faisceau en forme de « chapeau haut de forme » est imposé au rayon laser pour former la zone de contact, sachant que pour influencer le rayon laser (24) un convertisseur de faisceau, tel une optique réfractive ou diffractive ou un diaphragme, est éventuellement disposé entre le laser et la couche (14).

8. Procédé selon au moins l'une des précédentes revendications,
**caractérisé en ce**
**que** le laser (21) est pulsé par un interrupteur opto-acoustique.

9. Procédé selon au moins l'une des précédentes revendications, une cellule solaire faisant office de composant électronique, comprenant une première couche (10) constituée d'un matériau semi-conducteur comme substrat, une seconde couche (12) s'étendant sur cette dernière comme couche poreuse frittée en aluminium ou contenant de l'aluminium, au moins deux couches intermédiaires (16, 14) s'étendant entre la première et la seconde couche et conçues à partir des matériaux de la première et de la seconde couche, sachant que la première couche intermédiaire (16) tournée vers la seconde couche (12) peut contenir un mélange eutectique (18) des matériaux de la première et de la seconde couche, ainsi que la zone de contact (20) formant une liaison électriquement conductrice de la première couche, sachant qu'après le compactage et/ou l'enlèvement du matériau de la couche poreuse frittée dans la zone de contact à former, ce dernier est relié en étant conducteur électrique à un connecteur, en particulier par soudage, tel qu'un soudage par ultrasons.

10. Procédé selon au moins l'une des précédentes revendications,
**caractérisé en ce**
**qu'**une ou plusieurs couches permettant la mise en contact sont appliquées après le compactage et/ou l'enlèvement de la couche poreuse frittée sur la zone correspondante.
